# DEMANDE DE BREVET EUROPEEN

(11) **EP 1 322 117 A1**
(43) Date de publication de la demande: **25.06.2003**
(21) Numéro de dépôt: 02079938.3
(22) Date de dépôt: 27.11.2002
(51) Int. Cl.: H04N 7/26, H03M 7/40

(54) **Dispositif de codage/décodage arithmétique**

(30) Priorité: 06.12.2001 FR 0115779
(71) Demandeur: Koninklijke Philips Electronics N.V., 5621 BA Eindhoven (NL)
(72) Inventeur: Dombek, Thomas, c/o Société Civile S.P.I.D., 75008 Paris (FR)
(74) Mandataire: Chaffraix, Jean

(57) **Abrégé**

La présente invention concerne un dispositif de décodage (40) de données numériques codées (1) en fonction d'un contexte de données numériques décodées, comprenant des moyens de décodage arithmétique (11) des données numériques codées, aptes à fournir une donnée numérique décodée courante (2), des moyens de contrôle (13), aptes à délivrer une probabilité (4) aux moyens de décodage arithmétique à partir d'un mot de contexte (3), et un circuit de traitement (12), apte à stocker un ensemble de lignes de données numériques décodées et à fournir le mot de contexte (3) à partir de données numériques décodées précédentes. Le circuit de traitement est apte à effectuer un mouvement cyclique des données à l'intérieur des moyens de stockage de telle manière que les accès nécessaires à la formation du mot de contexte sont faits aux mêmes emplacements des moyens de stockage, permettant ainsi une extraction régulière du mot de contexte.

## Description

### Domaine technique de l'invention

La présente invention concerne un circuit de traitement de données numériques comprenant des moyens de stockage aptes à stocker un ensemble de lignes de données numériques et des moyens d'extraction aptes à fournir un mot de contexte à partir d'un ensemble de données numériques.

Elle concerne également un dispositif de décodage arithmétique de données numériques codées et un dispositif de codage arithmétique de données numériques comprenant un tel circuit de traitement.

Elle concerne enfin un procédé d'extraction de mots de contexte à partir de données numériques stockées sous forme d'un ensemble de lignes dans des moyens de stockage, un procédé de décodage arithmétique de données numériques codées et un procédé de codage arithmétique de données numériques.

Elle trouve notamment son application dans les codeurs et décodeurs pour télévision numérique conçus respectivement pour coder et décoder des données numériques multimédias compressées de type MPEG-4, et plus particulièrement les données numériques correspondant à la forme binaire d'objets vidéo qui sont compressées selon une technique de codage arithmétique basé sur un contexte (en anglais 'context-based arithmetic coding').

### Etat de la technique antérieure

Le standard de codage MPEG4 permet de coder indépendamment des objets vidéo appartenant à une même image. Pour cela, la forme d'un objet vidéo est représentée par une carte binaire. Pour chaque pixel d'un écran virtuel sur lequel un objet vidéo doit être projeté, une donnée binaire ou bit indique si ledit pixel appartient ou non à l'objet vidéo. Lesdites données binaires sont compressées par blocs de 16 lignes de 16 pixels, appelés macroblocs, sur lesquels est appliquée une méthode de codage arithmétique basé sur un contexte selon un principe connu de l'homme du métier. Pour chaque pixel d'un macrobloc, une probabilité d'appartenance à l'objet vidéo est déduite de la carte binaire. Ces probabilités sont utilisées lors du codage arithmétique. Elles sont calculées de telle manière que le décodeur est également capable de les déduire en utilisant uniquement des pixels précédemment décodés.

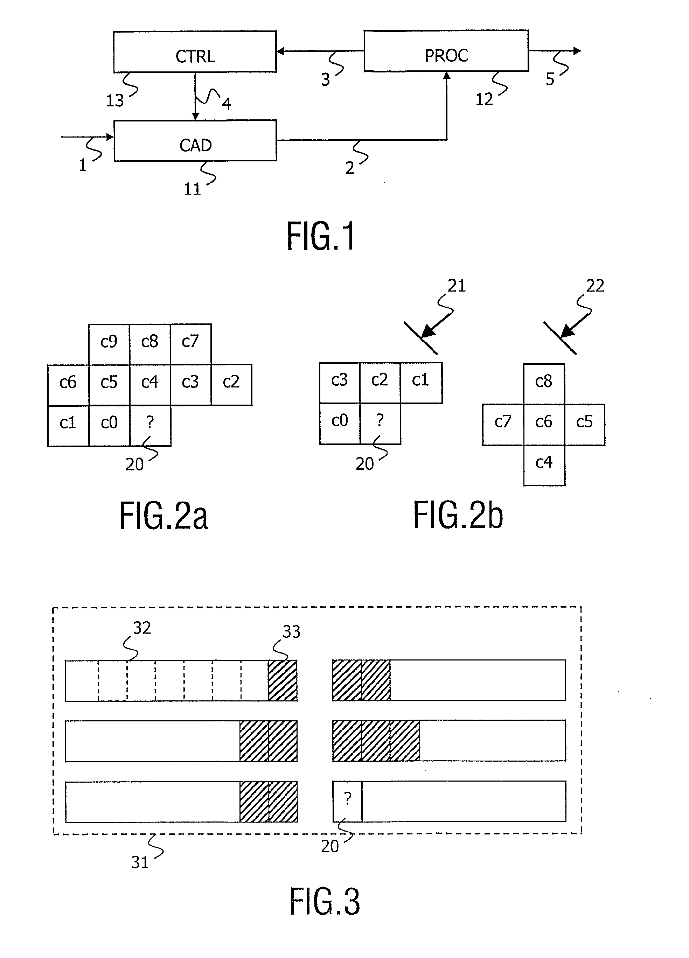

La Fig. 1 représente un schéma d'un procédé de décodage arithmétique basé sur un contexte. Il comprend une étape de décodage arithmétique CAD (11) d'un code arithmétique (1) destinée à fournir une valeur binaire d'un pixel (2). Il comprend également une étape de traitement PROC (12) destinée à extraire un mot de contexte (3) à partir de pixels précédemment décodés et à délivrer un ensemble de pixels décodés (5), un macrobloc par exemple. Il comprend enfin une étape de contrôle CTRL (13), destinée à délivrer une probabilité (4) à l'étape de décodage arithmétique à partir du mot de contexte (3). Ainsi, la connaissance du code arithmétique et de la probabilité liée à un contexte permet de décoder la valeur binaire d'un pixel. Ce pixel est alors utilisé avec d'autres pixels afin de déterminer le contexte et la probabilité du pixel suivant.

Selon le standard MPEG4, le mot de contexte se déduit de pixels déjà décodés selon le principe des Figs. 2a et 2b. La Fig. 2a illustre le calcul d'un mot de contexte pour un pixel courant (20) dans le cas d'un macrobloc INTRA, codé au moyen d'informations ne provenant que de lui-même et de deux lignes ou colonnes de macroblocs adjacents. Dans ce cas, le mot de contexte 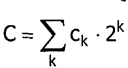 comprend 10 bits cₖ répartis sur 3 lignes avec cₖ=0 pour un pixel transparent et cₖ=1 pour un pixel opaque. La Fig. 2b illustre le calcul d'un mot de contexte pour un pixel courant (20) dans le cas d'un macrobloc INTER, codé par prédiction à compensation de mouvement à partir d'une zone de 18 lignes de 18 pixels comprenant un macrobloc de référence. Dans ce cas, le mot de contexte 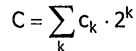 comprend 9 bits cₖ répartis sur 5 lignes, 2 lignes du macrobloc courant (21) et 3 lignes du macrobloc de référence (22).

Le procédé de décodage arithmétique basé sur un contexte est itératif. Ainsi à chaque itération, un mot de contexte est extrait. Comme les pixels sont stockés par macroblocs dans une mémoire incluse dans les moyens de traitement, ladite mémoire (31) étant, par exemple, organisée par mots (32) de 8 bits selon le schéma de la Fig. 3, les emplacements (33) de la mémoire auxquels il faut accéder pour récupérer les valeurs de pixels servant à former le mot de contexte changent à chaque itération. De plus le nombre de mots de la mémoire auxquels il faut accéder peut également changer lors d'une itération. Ainsi, l'extraction du mot de contexte selon le principe de l'état de la technique antérieure se fait de façon irrégulière.

### Exposé de l'invention

La présente invention a pour objet de proposer un circuit de traitement de données numériques comprenant des moyens de stockage aptes à stocker un ensemble de lignes de données numériques et des moyens d'extraction aptes à fournir un mot de contexte à partir d'un ensemble de données numériques, qui permette une extraction plus régulière d'un mot de contexte.

A cet effet, le circuit de traitement de données numériques selon l'invention est remarquable en ce que les moyens d'extraction comprennent des moyens de décalage des données numériques après l'extraction d'un mot de contexte, et de ré-ordonnancement desdites données à la fin du traitement d'une ligne de données numériques.

Ainsi, grâce aux moyens de décalage, les données numériques décodées sont décalées à chaque cycle d'horloge de manière à permettre aux moyens d'extraction d'accéder aux mêmes emplacements des moyens de stockage afin de récupérer les valeurs de pixels servant à former le mot de contexte. Dans le mode de réalisation préféré, les moyens de décalage comprennent des registres à décalage aptes à contenir des données numériques, et connectés entre eux de manière à permettre une permutation circulaire des données numériques sur une même ligne de données. De plus, les moyens de ré-ordonnancement permettent de réorganiser les données numériques décodées lorsqu'une ligne de données a été traitée. Dans le mode réalisation préféré, les moyens de ré-ordonnancement comprennent des registres à décalage connectés en diagonale de manière à permettre un ré-ordonnancement des données numériques d'une ligne courante sur une ligne précédente à la fin du traitement de la ligne courante.

La présente invention a remplacé l'accès irrégulier des données à différents emplacements des moyens de stockage tel qu'il est pratiqué dans l'état de la technique antérieure, par un mouvement cyclique des données à l'intérieur des moyens de stockage de telle manière que les accès nécessaires à la formation du mot de contexte sont faits aux mêmes emplacements des moyens de stockage. Il est ainsi possible de réaliser des connexions fixes des moyens de stockage notamment vers une table de probabilité destinée à associer une probabilité à un mot de contexte, rendant de ce fait l'extraction du mot de contexte plus régulière. La vitesse de traitement des données s'en trouve en outre accélérée puisqu'il est possible d'extraire un mot de contexte à chaque cycle d'horloge. Les ressources nécessaires à l'implémentation d'un tel dispositif sont également minimisées du fait de la simplicité de l'extraction des données, de même que les temps de latence sont diminués.

La présente invention a également pour objet un dispositif de décodage arithmétique de données numériques codées et un dispositif de codage arithmétique de données numériques comprenant un tel circuit de traitement, de manière à permettre une extraction plus régulière du mot de contexte servant à la détermination d'une probabilité nécessaire au décodage/codage arithmétique.

La présente invention a pour objet un décodeur de données numériques multimédias codées, notamment de type MPEG4, comprenant un tel dispositif de décodage, et un codeur de données numériques multimédias comprenant un tel dispositif de codage, qui soient plus efficaces.

La présente invention a enfin pour objet de proposer un procédé d'extraction de mots de contexte à partir de données numériques stockées sous forme d'un ensemble de lignes dans des moyens de stockage, un procédé de décodage arithmétique de données numériques codées et un procédé de codage arithmétique de données numériques, qui utilisent également une extraction plus régulière d'un mot de contexte.

### Brève description des dessins

Ces aspects de l'invention ainsi que d'autres aspects plus détaillés apparaîtront plus clairement grâce à la description suivante de plusieurs modes de réalisation de l'invention, donnés à titre d'exemples non limitatifs et en regard des dessins annexés parmi lesquels :
- la Fig. 1 représente un schéma général d'un procédé de décodage arithmétique basé sur un contexte,
- la Fig. 2a illustre le calcul d'un mot de contexte dans le cas d'un macrobloc INTRA,
- la Fig. 2b illustre le calcul d'un mot de contexte dans le cas d'un macrobloc INTER,
- la Fig. 3 illustre l'organisation d'une mémoire incluse dans les moyens de stockage et de traitement selon l'état de la technique antérieure,
- la Fig. 4 représente un dispositif de décodage arithmétique basé sur un contexte selon l'invention,
- la Fig. 5 illustre le principe de traitement des lignes d'un macrobloc selon l'invention,
- la Fig. 6 représente un décodeur MPEG4 intégrant un dispositif de décodage arithmétique basé sur un contexte selon l'invention,
- la Fig. 7 représente un dispositif de codage arithmétique basé sur un contexte, et
- la Fig. 8 représente un codeur MPEG4 intégrant un dispositif de codage arithmétique basé sur un contexte.

### Exposé détaillé d'au moins un mode de réalisation de l'invention

La présente invention concerne un circuit de traitement de données numériques. Elle a été développée dans le cadre du codage/décodage arithmétique basé sur un contexte de données numériques vidéo de type MPEG4 correspondant à la forme binaire d'un objet vidéo ou VOP (en anglais 'vidéo object plane') mais est applicable à d'autres types d'applications visant à extraire de façon régulière un mot de contexte à partir d'un ensemble de données numériques, binaires ou non, stockées dans une mémoire grâce à un mouvement cyclique des données à l'intérieur d'une mémoire.

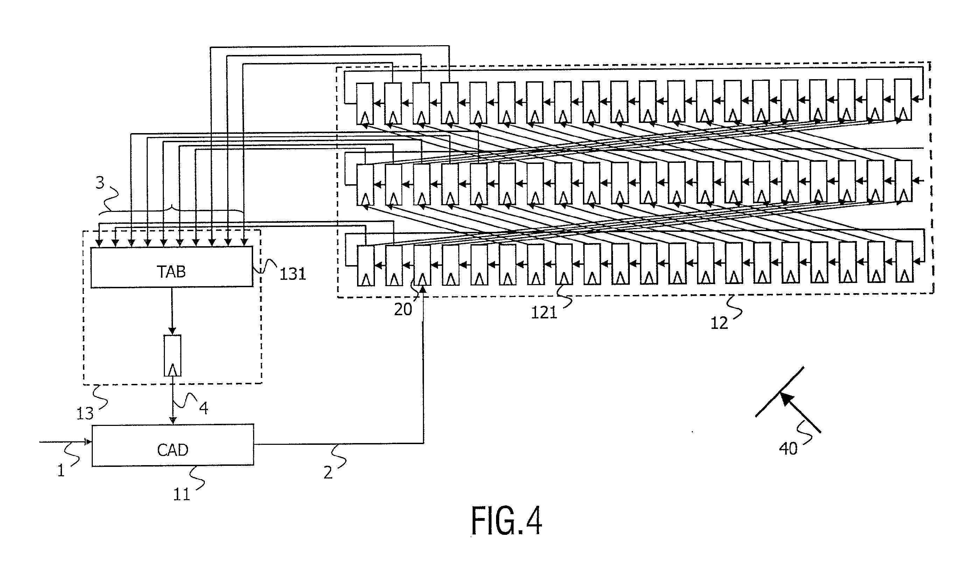

La Fig. 4 représente un dispositif de décodage arithmétique (40) basé sur un contexte selon l'invention. Le dispositif de décodage est apte à décoder des données numériques codées ou code arithmétique (1) en fonction d'un contexte de données numériques décodées, ici des valeurs binaires de pixels correspondant à l'appartenance ou la non-appartenance des pixels à un objet vidéo. Pour cela il comprend :
- des moyens de décodage arithmétique CAD (11) des données numériques codées, aptes à fournir une valeur binaire d'un pixel courant (2), selon un principe connu de l'homme du métier,
- un circuit de traitement de données numériques (12) comprenant des moyens de stockage aptes à stocker un ensemble de lignes de pixels et des moyens d'extraction aptes à fournir un mot de contexte (3) à partir d'un ensemble de valeurs de pixels précédents,
- des moyens de contrôle (13), aptes à délivrer une probabilité (4) aux moyens de décodage arithmétique à partir du mot de contexte (3), une table de probabilité TAB (131) faisant correspondre une probabilité à un mot de contexte.

Les moyens de stockage sont destinés à préserver les valeurs binaires de pixels qui sont nécessaires pour le décodage ou qui résultent du décodage, entre deux cycles d'horloge consécutifs. Selon le mode de réalisation préféré, lesdits moyens comprennent un réseau à deux dimensions de registres à décalage (121), chaque registre représentant un pixel. Les moyens de stockage sont construits de manière à contenir les données de nécessité immédiate au décodage ou sont aptes à contenir une plus grande quantité de données, agissant ainsi comme cache vis à vis d'autres supports de stockage à latence plus importante.

Les valeurs binaires nécessaires au décodage sont initialement chargées dans les moyens de stockage. Les moyens de stockage sont aptes à contenir au moins quelques lignes d'un macrobloc de pixels et de macroblocs adajacents audit macrobloc afin de tenir compte de la structure d'un mot de contexte. Dans le cas d'un macrobloc INTRA, au moins 3 lignes de 20 pixels sont nécessaires tandis que dans le cas d'un macrobloc INTER, au moins 5 lignes de 20 pixels sont nécessaires, 2 lignes d'un macrobloc courant et 3 lignes d'un macrobloc de référence. Les moyens de stockage peuvent également contenir un macrobloc entier ainsi que des fractions de macroblocs adajacents, soit une zone de 20 lignes de 20 pixels pour le macrobloc courant INTRA ou INTER et une zone de 18 lignes de 18 pixels pour le macrobloc de référence. Il va de soi que l'invention ne se limite pas à de telles dimensions des moyens de stockage. Il est, par exemple, possible d'optimiser le nombre de registres à décalage par lignes en tenant compte du fait que, d'une part, certains registres à décalages sont initialement vides (ils sont remplis par les données décodées par la suite), et que, d'autre part, le contenu de certains registres devient obsolète durant le décodage (par exemple, les valeurs de pixels de la zone de référence une fois le décodage effectué). Il est notamment possible, si un pré-chargement de la zone de référence de 18 lignes de 18 pixels est prévu, de remplacer progressivement les données obsolètes des éléments de stockage de cette zone par les données décodées.

Les moyens de stockage font partie du circuit de traitement (12), parfois appelé opérateur de contexte, et les registres à décalage sont connectés entre eux de manière à permettre une permutation circulaire des valeurs binaires de pixel sur une même ligne. Les registres à décalage sont également connectés en diagonale de manière à permettre un ré-ordonnancement des données numériques d'une ligne courante sur une ligne précédente à la fin du traitement de la ligne courante. Le circuit de traitement comprend en outre un contrôleur global apte à faire la sélection entre les moyens de décalage et les moyens de ré-ordonnancement via un multiplexage des différentes entrées des registres à décalage. Les registres à décalages sont ainsi connectés de manière fixe à la table de probabilité (131) des moyens de contrôle de manière à lui fournir le mot de contexte (3). La Fig. 4 illustre l'extraction d'un mot de contexte de 10 bits dans le cas d'un macrobloc INTRA. L'extraction d'un mot de contexte de 9 bits dans le cas d'un macrobloc INTER n'est pas décrite ici mais se fait selon un principe similaire avec au moins 5 lignes de valeurs binaires.

Les données numériques peuvent être traitées ligne par ligne ou colonne par colonne. Seul le traitement ligne par ligne est considéré par la suite, le second mode de traitement étant similaire au premier en ce sens qu'il peut être réalisé, par exemple, en symétrisant les données numériques par rapport à la diagonale d'un macrobloc.

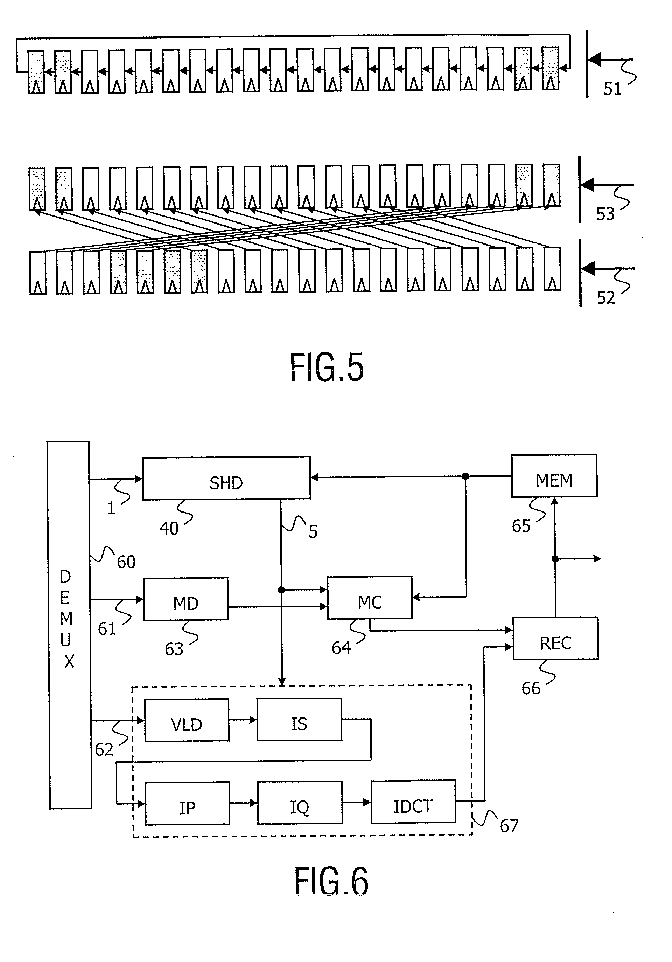

Le traitement des lignes d'un macrobloc est effectué selon le principe de la Fig. 5. Les registres à décalage (121) grisés correspondent aux pixels des macroblocs adjacents du macrobloc courant. Dans la configuration initiale (51) une ligne de 16 pixels d'un macrobloc courant est comprise entre deux pixels d'un macrobloc précédent et deux pixels d'un macrobloc suivant. Pendant les 15 premiers cycles d'horloge, les pixels sont décalés vers la gauche en direction du registre à décalage adjacent. La permutation circulaire n'a lieu que pour les lignes dont les registres à décalage sont connectés à la table de probabilité (131) des moyens de contrôle. Le seizième cycle d'horloge est effectué à la fin du traitement d'une ligne courante. Les données numériques de la ligne courante (52) telle que représentée lors du quinzième cycle d'horloge, sont alors transférées diagonalement dans les registres à décalage de la ligne précédente (53), représentée ici lors du seizième cycle d'horloge, reprenant ainsi une structure initiale avec une ligne de 16 pixels d'un macrobloc courant comprise entre deux pixels d'un macrobloc précédent et deux pixels d'un macrobloc suivant. Ces mouvements circulaires et diagonaux se répètent ensuite régulièrement tous les 16 cycles d'horloge.

la Fig. 6 représente un décodeur MPEG4 intégrant un tel dispositif de décodage arithmétique basé sur un contexte.

Le décodeur MPEG4 comprend un circuit de démultiplexage DEMUX (60), apte à séparer des données multimédias codées multiplexées en un code arithmétique (1) de la forme binaire d'un objet vidéo VOP, en des données codées de mouvement (61) et en des données codées de texture (62). Le décodeur MPEG4 comprend trois parties principales pour décoder ces différentes données :
- un dispositif de décodage arithmétique basé sur un contexte SHD (40) tel que décrit précédemment, apte à décoder le code arithmétique (1) en des valeurs de forme binaire (5),
- un décodeur de mouvement MD (63) suivi d'un compensateur de mouvement MC (64),
- un décodeur de données codées de texture (67).

Un objet vidéo VOP est reconstruit macrobloc par macrobloc, grâce à des moyens de reconstruction REC (66), en combinant les informations décodées de forme binaire, de mouvement et de texture. L'objet vidéo est stocké temporairement dans une mémoire d'image MEM (65).

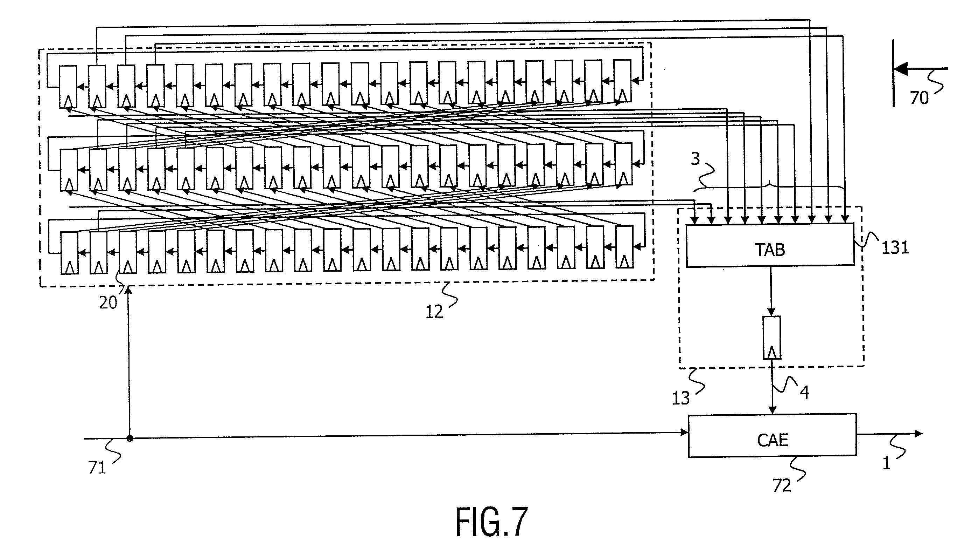

La Fig. 7 représente un dispositif de codage arithmétique basé sur un contexte (70) selon l'invention. Le dispositif de codage est apte à coder des valeurs binaires de pixels (71) en fonction d'un contexte desdits pixels. Pour cela il comprend :
- des moyens de codage arithmétique CAE (72) des valeurs binaires, aptes à fournir un code arithmétique (1),
- un circuit de traitement (12) tel que décrit précédemment, apte à stocker un ensemble de lignes de valeurs binaires de pixels et à fournir un mot de contexte (3) pour une valeur binaire d'un pixel courant à partir d'un ensemble de valeurs binaires de pixels précédents,
- des moyens de contrôle (13), aptes à délivrer une probabilité (4) aux moyens de codage arithmétique à partir du mot de contexte (3) et d'une table de probabilité TAB (131), les registres à décalage du circuit de traitement étant reliés par des connexions fixes à la table de probabilité (131).

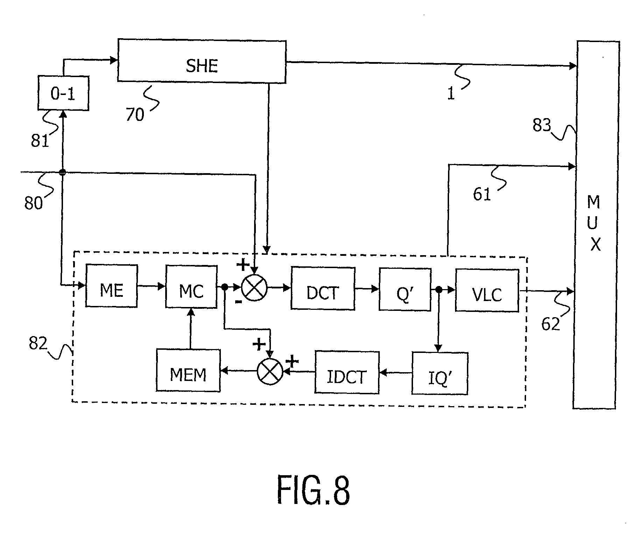

La Fig. 8 représente un codeur MPEG4 intégrant un tel dispositif de codage arithmétique basé sur un contexte. Le principe de fonctionnement du codeur MPEG4 est le suivant. Un objet vidéo VOP est divisé en macroblocs (80). Les valeurs correspondant à la forme binaire de l'objet vidéo sont déterminées (81) puis codées avec un dispositif de codage arithmétique basé sur un contexte (70) tel que décrit précédemment, qui fournit un code arithmétique (1) à un multiplexeur MUX (83). Une estimation de mouvement ME et une compensation de mouvement MC sont effectuées en utilisant des objets vidéo précédent ou suivant comme image de référence. L'erreur résiduelle entre un objet vidéo courant et un objet vidéo de référence est calculée puis codée par un codeur de texture (82) qui fournit au multiplexeur des informations codées de mouvement (61) et de texture (62).

L'extraction du mot de contexte (3) à partir de données numériques stockées sous forme d'un ensemble de lignes dans des moyens de stockage peut également se faire sous la forme d'un procédé comprenant les étapes de décalage des données numériques après l'extraction d'un mot de contexte, et de ré-ordonnancement desdites données à la fin d'un traitement d'une ligne de données numériques.

De même, le décodage de données numériques codées (1) en fonction d'un contexte de données numériques décodées, peut se faire sous la forme d'un procédé comprenant les étapes de décodage arithmétique des données numériques codées, destinée à fournir une donnée numérique décodée courante (2), de stockage d'un ensemble de lignes de données numériques décodées, d'extraction d'un mot de contexte (3) à partir de données numériques décodées précédentes, telle que précédemment décrite, et de contrôle, destinée à délivrer une probabilité (4) à l'étape de décodage arithmétique à partir du mot de contexte (3).

Enfin, le codage de données numériques (71) en fonction d'un contexte desdites données, peut se faire sous la forme d'un procédé comprenant les étapes de codage arithmétique des données numériques, destinée à fournir des données numériques codées (1), de stockage d'un ensemble de lignes de données numériques, d'extraction d'un mot de contexte (3) pour une donnée numérique courante à partir d'un ensemble de données numériques précédentes, telle que précédemment décrite, et de contrôle, destinée à délivrer une probabilité (4) à l'étape de codage arithmétique à partir du mot de contexte (3).

Aucun signe de référence entre parenthèses dans le présent texte ne doit être interprété de façon limitative. Le verbe "comprendre" et ses conjugaisons doivent également être interprétés de façon large, c'est à dire comme n'excluant pas la présence non seulement d'autres éléments ou étapes que ceux listés après ledit verbe, mais aussi d'une pluralité d'éléments ou d'étapes déjà listés après ledit verbe et précédés du mot "un" ou "une".

## Revendications

1. Circuit de traitement de données numériques (12) comprenant des moyens de stockage aptes à stocker un ensemble de lignes de données numériques et des moyens d'extraction aptes à fournir un mot de contexte (3) à partir d'un ensemble de données numériques, ledit circuit étant **caractérisé en ce que** les moyens d'extraction comprennent des moyens de décalage des données numériques après l'extraction d'un mot de contexte, et de ré-ordonnancement desdites données à la fin du traitement d'une ligne de données numériques.

2. Circuit de traitement de données selon la revendication 1, **caractérisé en ce que** moyens de décalage comprennent des registres à décalage aptes à contenir des données numériques, et connectés entre eux de manière à permettre une permutation circulaire des données numériques sur une même ligne.

3. Circuit de traitement de données selon la revendication 1 ou 2, **caractérisé en ce que** moyens de ré-ordonnancement comprennent des registres à décalage connectés en diagonale de manière à permettre un ré-ordonnancement des données numériques d'une ligne courante sur une ligne précédente à la fin du traitement de la ligne courante.

4. Dispositif de décodage (40) de données numériques codées (1) en fonction d'un contexte de données numériques décodées, comprenant :
- des moyens de décodage arithmétique (11) des données numériques codées, aptes à fournir une donnée numérique décodée courante (2),
- des moyens de contrôle (13), aptes à délivrer une probabilité (4) aux moyens de décodage arithmétique à partir d'un mot de contexte (3),
ledit dispositif étant **caractérisé en ce qu'**il comprend un circuit de traitement (12) selon l'une des revendications 1 à 3, apte à stocker un ensemble de lignes de données numériques décodées et à fournir le mot de contexte (3) à partir de données numériques décodées précédentes.

5. Dispositif de codage (70) de données numériques (71) en fonction d'un contexte desdites données, comprenant :
- des moyens de codage arithmétique (72) des données numériques, aptes à fournir des données numériques codées (1),
- des moyens de contrôle (13), aptes à délivrer une probabilité (4) aux moyens de codage arithmétique à partir d'un mot de contexte (3),
ledit dispositif étant **caractérisé en ce qu'**il comprend un circuit de traitement (12) selon l'une des revendications 1 à 3, apte à stocker un ensemble de lignes de données numériques et à fournir le mot de contexte (3) pour une donnée numérique courante à partir d'un ensemble de données numériques précédentes.

6. Décodeur de données numériques multimédia, notamment de type MPEG4, comprenant un dispositif de décodage selon la revendication 4, apte à décoder des données numériques codées correspondant à une forme binaire des données numériques multimédia.

7. Codeur de données numériques multimédia, notamment de type MPEG4, comprenant un dispositif de codage selon revendication 5, apte à coder des données numériques correspondant à une forme binaire des données numériques multimédia.

8. Procédé d'extraction de mots de contexte (3) à partir de données numériques stockées sous forme d'un ensemble de lignes dans des moyens de stockage **caractérisé en ce qu'**il comprend les étapes de décalage des données numériques après l'extraction d'un mot de contexte, et de ré-ordonnancement desdites données à la fin d'un traitement d'une ligne de données numériques.

9. Procédé de décodage de données numériques codées (1) en fonction d'un contexte de données numériques décodées, comprenant les étapes :
- de décodage arithmétique des données numériques codées, destinée à fournir une donnée numérique décodée courante (2),
- de stockage d'un ensemble de lignes de données numériques décodées,
- d'extraction d'un mot de contexte (3) à partir de données numériques décodées précédentes,
- de contrôle, destinée à délivrer une probabilité (4) à l'étape de décodage arithmétique à partir du mot de contexte (3),
ledit procédé étant **caractérisé en ce que** l'étape d'extraction comprend les sous-étapes de décalage des données numériques décodées après l'extraction d'un mot de contexte, et de ré-ordonnancement desdites données à la fin du décodage d'une ligne de données numériques.

10. Procédé de codage de données numériques (71) en fonction d'un contexte desdites données, comprenant les étapes :
- de codage arithmétique des données numériques, destinée à fournir des données numériques codées (1),
- de stockage d'un ensemble de lignes de données numériques,
- d'extraction d'un mot de contexte (3) pour une donnée numérique courante à partir d'un ensemble de données numériques précédentes,
- de contrôle, destinée à délivrer une probabilité (4) à l'étape de codage arithmétique à partir du mot de contexte (3),
ledit procédé étant **caractérisé en ce que** l'étape d'extraction comprend les sous-étapes de décalage des données numériques après l'extraction d'un mot de contexte, et de ré-ordonnancement desdites données à la fin du codage d'une ligne de données numériques.
